(19) Europäisches Patentamt
European Patent Office
Office européen des brevets

(11) **EP 4 300 822 A1**

(12) **EUROPEAN PATENT APPLICATION**

(43) Date of publication:
**03.01.2024 Bulletin 2024/01**

(21) Application number: **22181610.1**

(22) Date of filing: **28.06.2022**

(51) International Patent Classification (IPC):
$H03F\ 3/45$ (2006.01)     $H02M\ 1/12$ (2006.01)
$H02M\ 1/44$ (2007.01)     $H02M\ 1/15$ (2006.01)

(52) Cooperative Patent Classification (CPC):
**H03F 3/45475; H02M 1/12; H02M 1/15; H02M 1/44**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Collins Aerospace Ireland, Limited
Cork (IE)**

(72) Inventors:
• **CUESTA CANO, Tania
  Cork (IE)**
• **CASTRO ÁLVAREZ, Ignacio
  Gijón (ES)**
• **POPEK, Grzegorz
  Birmingham (GB)**

(74) Representative: **Dehns
  St. Bride's House
  10 Salisbury Square
  London EC4Y 8JD (GB)**

(54) **ACTIVE EMI FILTER**

(57)     An active electromagnetic interference filter comprising an adjustable shunt impedance circuit, the adjustable shunt impedance circuit comprising a noise sensing branch that senses input noise and provides a noise voltage representative of the sensed noise, and an operational amplifier stage configured to generate, at an injection branch, an injection current based on the noise voltage.

FIG.3

**Description**

TECHNICAL FIELD

The present disclosure is concerned with EMI filters for use in a power train and particularly active EMI filters for EMI reduction in e.g. motor drive systems.

BACKGROUND

The presence of power converters and particularly power converters that use high frequency switching, in a power drive or distribution system, gives rise to conducted electromagnetic interference (EMI). EMI noise is typically attenuated using passive EMI filters which are low-pass filters comprising e.g. an inductor and capacitor circuit. The capacitor may be coupled to earth to act as a shunt or path for leakage current. Safety constraints, however, limit the amount of current that may be shunted and so the range of suitable capacitor sizes is limited. Also, limiting the capacitance of the filter to minimise leakage current results in the need for the inductor part of the filter to be large to provide the required LC value for the required noise reduction. Higher value inductors are larger in size and add to the overall weight, size and cost of the filter. While passive EMI filters are simple and reliable, they can, therefore, be bulky and heavy. Power converters and distribution systems are being used in an increasing number of applications including in the automotive and in the aerospace industries. In these fields, the constraints in terms of size and weight are strict and the passive EMI filter designs contribute negatively to meeting those constraints. There is a need for high power density solutions in EMI noise management.

To address the issues with passive EMI filters, active EMI filters have been developed in which the conducted noise current is cancelled by the action of the active circuit. An active EMI filter generates a noise cancellation signal. Active EMI filters are able to attenuate noise at low frequencies. Combined with a passive filter for handling just the high frequency noise, this can lead to a lighter and smaller solution. Various active EMI filters are known: some detect noise voltage and generate an injection current, others detect noise current; some use a feedforward control and others use feedback control. The existing active EMI filters, however, require additional components such as transformers or large capacitors, adding to the overall size, weight and cost. The active filters can also suffer magnetic saturation that degrades filter performance. On the other hand, active filter solutions can use only capacitor coupling which has advantages in terms of small size, making them attractive for applications where available space is limited e.g. in aircraft.

Whilst current EMI filter solutions work well, there is a need for an improved active EMI filter design.

SUMMARY

According to the present disclosure, there is provided an active electromagnetic interference filter comprising an adjustable shunt impedance circuit, the adjustable shunt impedance circuit comprising a noise sensing branch that senses input noise and provides a noise voltage representative of the sensed noise, and an operational amplifier stage configured to generate, at an injection branch, an injection current based on the noise voltage.

The adjustable shunt impedance circuit may comprise two or more op-amp stages including a shaping stage and a decoupling stage and, optionally, a boosting stage.

A lightning protection switch may also be provided.

BRIEF DESCRIPTION

Examples of the active EMI filter of this disclosure will now be described with reference to the drawings. It should be noted that variations are possible within the scope of the claims.

Figure 1 shows a power train configuration in which an active EMI filter according to the disclosure may be used.

Figure 2A represents a typical passive EMI filter.

Figure 2B represents a typical active EMI filter.

Figure 3 shows a simplified single-phase representation of an active EMI filter according to the disclosure.

Figure 4A is a simple schematic representation of a two-stage active impedance configuration.

Figure 4B is a simple schematic representation of a three-stage active impedance configuration.

Figure 5 is a simple circuit diagram of an active EMI filter design according to the disclosure.

Figure 6 is a variation of the first stage of a design such as in Fig. 5.

DETAILED DESCRIPTION

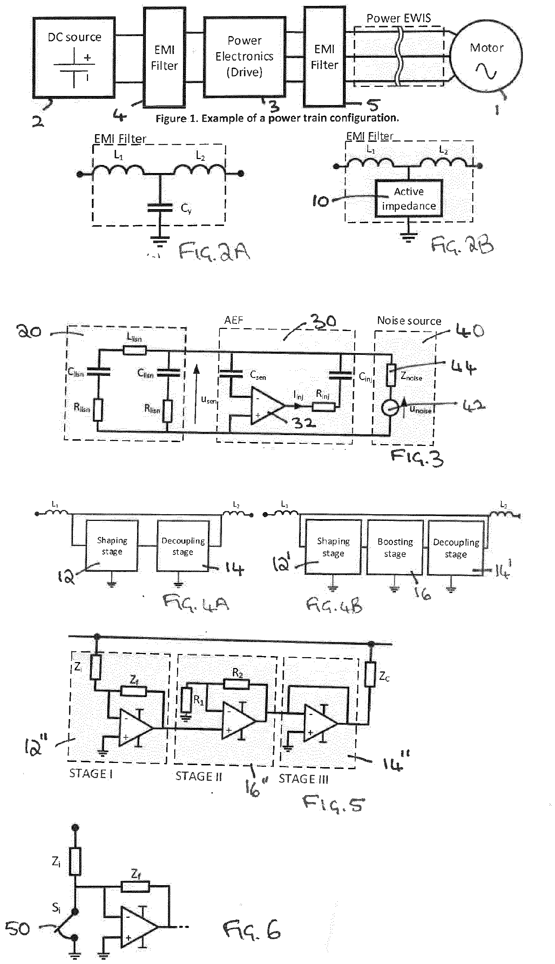

A typical power train will first be described, with reference to Fig. 1, by way of background. This is just one example of a power train in which the active EMI filter can be used.

The drive train drives a load e.g. a motor 1 from a DC source 2. Power electronics 3 convert the power from the source using a system of switches (not shown) and control the power to be provided to the motor 1. EMI filters 4, 5 are typically provided at the input end and the output side of the power electronics 3 to filter differential mode and common mode EMI (noise) generated by the system. This is well known and will not be described in further detail.

One solution for the EMI filter is a passive EMI filter which may have a topology as shown in Fig. 2A, comprising a series inductance ($L_1$, $L_2$) and one or more shunt capacitors $C_y$ connected to ground (e.g. to a vehicle chassis). The design of the passive filter, however, needs to be carefully considered, since it affects the stability of the whole system. Where safety standards limit the maximum permitted leakage current allowed to flow to ground, the size of the capacitor is limited, which means that to obtain the desired filter LC value for filtering noise, the inductance value must be larger, as described in the background, above.

An active filter, as seen in Fig. 2B, has an active impedance/capacitor 10 to ground which addresses some of the problems with passive filters. An active filter can be used instead of or in combination with a passive filter.

The present disclosure provides a design for the active impedance 10 using a feedback compensation method with voltage sensing and current injection. This enables the shunt impedance of any kind of EMI filter to be modified to fit within noise emission limits as well as safety standards, whilst being lightweight and compact.

Figure 3 shows a simple circuit view of a filter design according to the disclosure for a single-phase, for simplicity and ease of explanation. The design can, of course, be adapted for multi-phase applications.

The Figure shows a known line impedance stabilisation network (LISN) stage 20 and an active impedance stage 30 which, in fig 3, is connected to the noise source 40 represented as a noise voltage $U_{noise}$ 42 and a noise impedance $Z_{noise}$ 44. The LISN stage detects the noise from the noise source 40 and creates a precise impedance to provide a measurement of the noise as a sensed voltage signal $U_{sen}$. The LISN components are represented in Fig. 3 as $L_{lisn}$, $C_{lisn}$ and $R_{lisn}$. The active impedance stage 30 (corresponding to the active impedance 10 in Fig. 2B) includes a sensing branch and an injection branch. The sensing branch includes a decoupling capacitor $C_{sen}$ and the sensed voltage signal $U_{sen}$. An operational amplifier 32 outputs a voltage signal based on the sensed voltage signal $U_{sen}$, that generates an injection current $I_{inj}$ because of the voltage difference created over the injection branch. The injection branch provides an injection impedance represented by $R_{inj}$ and $C_{inj}$.

The active impedance 10, 30 can be implemented in two or more stages depending on the desired impedance amplification ratio. Figure 4A sows the active impedance as a two-stage design with a shaping stage 12 and a decoupling stage 14, and Fig. 4B shows a three-stage implementation having a boosting stage 16 between the shaping stage 12' and the decoupling stage 14'. Additional stages may be required or each stage could be formed using several circuits, to generate the required shunt impedance 10.

The three stage implementation will now be described in more detail, by way of example only, with reference to Fig. 5. The first stage 12" is responsible for impedance shaping and is in the form of an inverting operational amplifier. The input impedance $Z_{i,}$ of the input branch, and the feedback impedance $Z_f$ are selected accordingly to define the impedance behaviour across the frequency range of interest. The impedance shaping stage 12" has to be carefully designed to provide the required impedance whilst being stable. In an example for aerospace, the regulation range of the DO-160 standard is set from e.g. 150 kHz to 30MHz. To cover the majority of this range, a good approach could be to design the active EMI filter to cover from 150kHz to 10MHz. The impedance of the injection branch (represented in Fig. 3 as $R_{inj}$ and $C_{inj}$) is represented in Fig. 5 as $Z_c$. The op-amp configuration and the injection branch result in the impedance expression for the shunt impedance Z according to the equation:

$$\frac{1}{Z} = \frac{1}{Zi} + \frac{1}{Zc}\left(1 + \frac{Zf}{Zi}\right)$$

Or, if the boosting stage 16, 16" is present:

$$\frac{1}{Z} = \frac{1}{Zi} + \frac{1}{Zc}\left(1 + \frac{Zf}{Zi} \cdot \frac{R2}{R1}\right)$$

Because the injection branch (here represented as $Z_c$) has a capacitive characteristic, it degrades the stability of the op-amp circuit, whereas, as mentioned above, the impedance shaping stage needs to generate a stable impedance along the whole frequency range. The inclusion of a decoupling stage 14" decouples the injection branch, and thus the effect of this over the stability of the shaping stage 12" and, where present, the boosting stage 16" and thus can significantly improve the stability of the filter reaching good behaviour up to higher frequencies. The boosting stage 16" is an amplification stage, in the form of a non-inverting op-amp, that can be included when required to amplify the impedance, within the frequency range, and, therefore, increase the range of possible impedances Z. This stage can, however, be omitted.

Thus, as seen from the equation above, the resultant shunt impedance Z of the active EMI filter is defined by the impedance characteristics of the injection branch and the sensing branch multiplied by a gain element defined by the ratio of the feedback impedance and the sensing impedance and, if the boosting stage 16" is present, also the boosting stage gain. If a boosting stage 16" is included between the impedance shaping stage 12" and the decoupling stage 14", the shunt impedance can be magnified whilst maintaining the frequency performance. A gain term multiplying the feedback and input impedance ratio appears.

The AEF of this design, represented as 30 in Fig. 3, example stages of which are shown in Figs. 4A and 4B, and in further detail in Fig. 5, implements the active impedance 10 of the active filter in Fig. 2B and replaces the capacitor $C_y$ of the passive filter in Fig. 2A, thus addressing the problems of such designs as described above.

When designing EMI filters, it is often necessary to ensure that the shunt capacitance has a minimum value to guarantee the safety standard limitation of current flowing to ground, typically based on lightning conduction requirements. The filter design of this disclosure, as described above, can be adapted to ensure this minimum capacitance of the active shunt impedance by incorporating a normally closed switch 50, shown in Fig. 8 in the impedance shaping stage 12". The switch may be a normally closed device e.g. a JFET device or the like. When the switch is not activated (i.e. closed), the $Z_i$ is connected directly to ground and the active impedance circuitry is disabled. When the switch is opened, the $Z_i$ is connected to $Z_f$ only and the active impedance circuitry will be enabled. If the switch is closed, therefore, the active impedance circuitry is disabled and the minimum safety shunt capacitance will still be satisfied by the input impedance $Z_i$, providing reduced impedance to the conduction of lightning to ground.

The active filter design of the disclosure can achieve noise attenuation that is comparable with or better than known passive EMI filters for a significantly smaller size and weight design. There is a high degree of flexibility in shaping the shunt impedance and so safety criteria can be met over a range of frequencies. The overall EMI filter of the disclosure has good efficiency which can have the effect of reducing the contribution required from any cooling system.

**Claims**

1. An active electromagnetic interference filter comprising an adjustable shunt impedance circuit, the adjustable shunt impedance circuit comprising a noise sensing branch that senses input noise and provides a noise voltage representative of the sensed noise, and an operational amplifier stage configured to generate, at an injection branch, an injection current based on the noise voltage.

2. The active electromagnetic interference filter of claim 1, wherein the noise sensing branch includes a decoupling capacitor and provides the noise voltage as a sensed voltage signal to the operational amplifier stage, and wherein the operational amplifier stage outputs a voltage signal that generates an injection current.

3. The active electromagnetic interference filter of claim 1 or 2, wherein the operational amplifier stage comprises a shaping stage (12) and a decoupling stage (14).

4. The active electromagnetic interference filter of claim 3, wherein the shaping stage comprises an inverting operational amplifier.

5. The active electromagnetic interference filter of claim 3 or 4, wherein the decoupling stage comprises an operational amplifier.

6. The active electromagnetic interference filter of claim 3, 4 or 5, wherein the operational amplifier stage further comprises a boosting stage (16) connected between the shaping stage and the decoupling stage.

7. The active electromagnetic interference filter of claim 6, wherein the boost stage comprises an operational amplifier.

8. The active electromagnetic interference filter of any preceding claim, further comprising a switch to disable the adjustable shunt impedance circuit in a lightning condition.

9. The active electromagnetic interference filter of claim 8, wherein the switch (50) is a normally closed switch.

10. The active electromagnetic interference filter of claim 9, wherein the switch is a normally closed JFET device.

11. The active electromagnetic interference filter of any preceding claim, being a T-filter having an input impedance at the input to the adjustable shunt impedance circuit and an output impedance at the output of the adjustable shunt impedance circuit.

12. A power train for providing power to one or more loads, and comprising an active electromagnetic interference filter as claimed in any preceding claim.

13. The power train of claim 12, comprising a power source (2) and a load (1) to be driven from the power source, power electronics (3) between the power source and the load to convert power from the source for the load, and one or more active electromagnetic interference filters as claimed in any of claims 1 to 11.

Figure 1. Example of a power train configuration.

FIG. 2A

FIG. 2B

FIG. 3

FIG. 4A

FIG. 4B

FIG. 5

FIG. 6

Europäisches
Patentamt
European
Patent Office
Office européen
des brevets

# EUROPEAN SEARCH REPORT

Application Number

EP 22 18 1610

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/292401 A1 (SHEN MIAOSEN [US]) 2 October 2014 (2014-10-02) * paragraph [0025]; figures 2d, 11 * | 1-7, 11-13 | INV. H03F3/45 H02M1/12 H02M1/44 H02M1/15 |
| X | US 2020/373831 A1 (CHU YONGBIN [US] ET AL) 26 November 2020 (2020-11-26) * paragraphs [0015] – [0024]; figures 1,2 * | 1-7, 11-13 | |
| X | EP 2 696 486 A2 (HAMILTON SUNDSTRAND CORP [US]) 12 February 2014 (2014-02-12) * paragraphs [0012] – [0019]; figures 1,2 * | 1-7, 11-13 | |
| X | EP 2 709 250 A1 (NXP BV [NL]) 19 March 2014 (2014-03-19) * paragraphs [0051] – [0061], [0074] – [0078]; figures 1a,1b,2,5,6 * | 1-7, 11-13 | |
| A | CN 114 094 816 A (DONGGUAN KAIYUN TECH CO LTD) 25 February 2022 (2022-02-25) * abstract; figure 2 * | 1-7, 11-13 | TECHNICAL FIELDS SEARCHED (IPC) H03F H02M |

The present search report has been drawn up for all claims

| Place of search | Date of completion of the search | Examiner |
|---|---|---|
| The Hague | 23 November 2022 | Zakharian, Andre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**Application Number**

**EP 22 18 1610**

---

## CLAIMS INCURRING FEES

The present European patent application comprised at the time of filing claims for which payment was due.

◻ Only part of the claims have been paid within the prescribed time limit. The present European search report has been drawn up for those claims for which no payment was due and for those claims for which claims fees have been paid, namely claim(s):

◻ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

◻ All further search fees have been paid within the fixed time limit. The present European search report has been drawn up for all claims.

◻ As all searchable claims could be searched without effort justifying an additional fee, the Search Division did not invite payment of any additional fee.

◻ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-7, 11-13

◻ The present supplementary European search report has been drawn up for those parts of the European patent application which relate to the invention first mentioned in the claims (Rule 164 (1) EPC).

| | | LACK OF UNITY OF INVENTION | Application Number |
|---|---|---|---|
| | Europäisches Patentamt European Patent Office Office européen des brevets | SHEET B | EP 22 18 1610 |

The Search Division considers that the present European patent application does not comply with the requirements of unity of invention and relates to several inventions or groups of inventions, namely:

> **1. claims: 1-7, 11-13**
>
> > **Details of an active EMI filter**
> > **---**
>
> **2. claims: 8-10**
>
> > **Protection of an active EMI filter and providing a nominal**
> > **input impedance in hazardous conditions.**
> > **---**

## ANNEX TO THE EUROPEAN SEARCH REPORT
## ON EUROPEAN PATENT APPLICATION NO.

EP 22 18 1610

This annex lists the patent family members relating to the patent documents cited in the above-mentioned European search report.
The members are as contained in the European Patent Office EDP file on
The European Patent Office is in no way liable for these particulars which are merely given for the purpose of information.

23-11-2022

| Patent document cited in search report | | Publication date | Patent family member(s) | | Publication date |
|---|---|---|---|---|---|
| US 2014292401 | A1 | 02-10-2014 | EP | 2787618 A1 | 08-10-2014 |
| | | | US | 2014292401 A1 | 02-10-2014 |
| US 2020373831 | A1 | 26-11-2020 | US | 2018294714 A1 | 11-10-2018 |
| | | | US | 2020373831 A1 | 26-11-2020 |
| EP 2696486 | A2 | 12-02-2014 | EP | 2696486 A2 | 12-02-2014 |
| | | | US | 2014043871 A1 | 13-02-2014 |
| EP 2709250 | A1 | 19-03-2014 | EP | 2709250 A1 | 19-03-2014 |
| | | | US | 2014071719 A1 | 13-03-2014 |
| CN 114094816 | A | 25-02-2022 | NONE | | |

EPO FORM P0459

For more details about this annex : see Official Journal of the European Patent Office, No. 12/82